Europäisches Patentamt

European Patent Office

Office européen des brevets

(19)

(11) Publication number: **0 216 803 B1**

# EUROPEAN PATENT SPECIFICATION

(12)

(45) Date of publication of patent specification: **31.03.93**

(51) Int. Cl.5: **H04B 1/04**, H03D 1/22, H04B 1/30

(21) Application number: **86901242.7**

(22) Date of filing: **30.01.86**

(86) International application number:
**PCT/US86/00219**

(87) International publication number:
**WO 86/05936 (09.10.86 86/22)**

(54) **DIGITAL ZERO-IF SELECTIVITY SECTION.**

(30) Priority: **04.04.85 US 720311**

(43) Date of publication of application:
**08.04.87 Bulletin 87/15**

(45) Publication of the grant of the patent:
**31.03.93 Bulletin 93/13**

(84) Designated Contracting States:
**AT BE CH DE FR GB IT LI LU NL SE**

(56) References cited:
US-A- 3 979 701   US-A- 3 988 539
US-A- 4 003 002   US-A- 4 011 438
US-A- 4 062 060   US-A- 4 071 821
US-A- 4 130 806   US-A- 4 159 526
US-A- 4 237 554   US-A- 4 475 220
US-A- 4 506 228

**No relevant documents have been disclosed.**

(73) Proprietor: **MOTOROLA, INC.**
**1303 East Algonquin Road**
**Schaumburg, IL 60196(US)**

(72) Inventor: **JASPER, Steven, C.**
**4370 Haman Court**
**Hoffman Estates, IL 60195(US)**
Inventor: **LONGLEY, Lester, A.**
**910 North Lake Shore Drive**
**Chicago, IL 60611(US)**
Inventor: **LAMBERT, Katherine, H.**
**21 Kristin Drive**
**Schaumburg, IL 60195(US)**

(74) Representative: **Ibbotson, Harold et al**
**MOTOROLA European Intellectual Property**
**Operations Jays Close Viables Ind. Estate**
**Basingstoke Hants RG22 4PD (GB)**

(74) Representative: **Hudson, Peter David**
**Motorola Ltd. Patent and Licensing Operations - Europe Jays Close Viables Industrial**
**Estate**
**Basingstoke Hampshire RG22 4PD (GB)**

Rank Xerox (UK) Business Services
(3.10/3.5x/3.0.1)

**Description**

This invention relates generally to intermediate frequency circuits and more particularly to digital intermediate frequency circuits where the intermediate frequency is zero Hertz.

Historically, intermediate frequency (IF) sections have been employed in transmitters and receivers to perform the major portion of a radio's selectivity since it may be technically difficult, or cost prohibitive, to develop sufficiently selective filters at the transmitted or received frequency. Transceivers may have more than one IF section. For example, some receivers employ two IF sections for recovering the transmitted information. These receivers are generally referred to as dual conversion receivers, whereas a single IF receiver would be referred to as a singular conversion receiver. Generally, any receiver with an intermediate frequency of zero Hertz is referred to as a direct conversion receiver.

Analog implementations of direct conversion receivers suffer from a variety of detriments including local oscillator (LO) radiation, which results from imperfect reverse isolation through the mixers, and may desense nearby receivers. Further, radio desense performance can be degraded by nonlinear effects in the mixers causing self-mixing of on-and off-channel signals which creates DC offsets and audio distortion. Also, in an application involving the reception of frequency modulated (FM) signals, the direct conversion analog receiver has no means of limiting the zero-IF signal. This causes unpredictable performance in fading and other adverse conditions.

The aforementioned dual conversion receiver alleviates some of the direct conversion problems. The additional isolation obtained by a dual conversion receiver solves the LO radiation problem. However, the solution is achieved at the cost of an additional mixer and local oscillator, in addition to a narrow band (generally crystal) filter to achieve the required isolation. Further, having a traditional IF section prior to the DC-IF section essentially band-limits the incoming signal to one channel. Thus, the self-mixing products caused by the nonlinear effects of the mixers generally will not fall into the passband of the filter in a dual conversion receiver.

Although the dual conversion receiver solves many of the problems experienced by the direct conversion receiver (although at additional cost and size requirements), the dual-conversion receiver experiences other detriments. As previously mentioned, the direct conversion FM receiver cannot limit the zero-IF signal. Thus, the use of unconventional detection methods are required. The typical solution to this problem is to up-convert the zero-IF signal to a third IF frequency where it can be limited and detected using conventional circuits. Up-converting requires another local oscillator, additional mixers and a summing circuit. Further, up-converting creates yet another problem. The quadrature paths in an analog receiver cannot be perfectly balanced for amplitude and phase characteristics because of the nonexact performance of the mixers and filters. Thus, a beat-note is (created due to imperfect cancellation in the summer) which degrades hum and noise performance and causes audio distortion. A proposed solution to this problem is to phase lock the LO to an incoming pilot signal. This necessitates additional circuitry at the transmitter to transmit the pilot signal and also requires additional circuitry at the receiver to develop the phase lock loop and pilot filters. Lastly, the phase lock loop lock-time and pull-in range become critical receiver parameters.

US-A-4,506,228 describes a FM receiver comprising a digital zero-IF selectivity section and US-A-4,011,438 and US-A-4,475,220 describe DZ1SS circuits with digital quadrature multipliers and digital low-pass filters.

Although the above discussion has concerned receivers, similar problems are experienced in transmitter IF sections, even though transmitter IF topologies are generally different to those employed in receivers.

Summary of the Invention

In accordance with the present invention, there is provided a digital zero-IF selectivity section according to claims 1,2 and 7.

In practicing the invention, the digital quadrature local oscillator is employed to generate digitized discrete-time amplitude pulses of sine and consine waveforms which are then combined with an input signal in a digital quadrature mixer. In a receiver, the digital quadrature mixer down-converts the input signal to occupy a frequency band centered about zero Hertz. Subsequent digital filtering removes any unwanted mixing components so that only the signal centered about zero Hertz is communicated to any recovery circuitry in the receiver. In a transmitter, the digital quadrature mixer up-converts a digitally filtered input signal to occupy a frequency band centered about the selected frequency of the local oscillator signals.

The digital zero-IF selectivity section has a topology that can be used for both transmitters and receivers. It is capable of operating at high sampling rates.

The digital zero-IF approach avoids the above mentioned problems in the prior art. The mixers are linear, and the two quadrature paths may be matched. A conventional first IF section is not required in the digital implementation and the dynamic range of the digital zero-IF section can be made as large as necessary by selecting appropriate data word lengths. Digital FM detection can be performed directly at DC eliminating the need to up-convert to a third IF, and the need for a phase-locking arrangement to a pilot signal.

Brief Description of the Drawings

The features of the present invention which are believed to be novel are set forth with particularity in the appended claims. The invention, together with further objects and advantages thereof, may be understood by reference to the following description taken in conjunction with the accompanying drawings, and the several figures of which like referenced numerals identify like elements and in which:

Figure 1 is a block diagram of a digital zero-IF selectivity section especially adapted for use in a receiver;

Figure 2 is a block diagram of the digital zero-IF selectivity section especially adapted for use in a transmitter;

Figure 3 is a block diagram of the digital quadrature LO of Figures 1 and 2;

Figure 4a is a block diagram of the digital lowpass filters of Figure 1;

Figure 4b is a block diagram of the digital low pass filters of Figure 2;

Figure 5 is a block diagram of one of the lowpass filter sections of Figure 4a or Figure 4b;

Figure 6 is graphical representation of the response of the digital low pass filter section of Figure 5.

Figures 7a-c are graphical representations of a filter decomposition technique and resulting filter response;

Figure 8 is a graphical representation of a combining filter technique used in the prior art;

Figures 9a-b are graphical representations of the combining filter technique and filter response as taught by the present invention;

Figure 10 is a graphical representation of a decomposed and combined filter response as taught by the present invention;

Figure 11 is an embodiment of a digital low pass filter section having the response shown in Figure 10;

Figures 12a-c are time domain and frequency domain representations of exemplary signals appearing at point A of Figure 1;

Figures 13a-c are time domain and frequency domain representations of exemplary signals appearing at point B of Figure 1;

Figures 14a-c are time domain and frequency domain representations of exemplary signals appearing at point C of Figure 1;

Figures 15a-c are time domain and frequency domain representations of exemplary signals appearing at point D of Figure 1;

Figure 16 is a block diagram of a receiver employing the digital zero-IF selectivity section of Figure 1;

Figure 17 is a block diagram of a transmitter employing the digital zero-IF selectivity section of Figure 2;

Figure 18 is a block diagram of an alternate embodiment of the digital zero-IF selectivity section where the digital lowpass filters are divided into high speed and low speed sections and the low speed sections are time multiplexed which effectuate a cost and space savings.

Detailed Description of the Preferred Embodiment

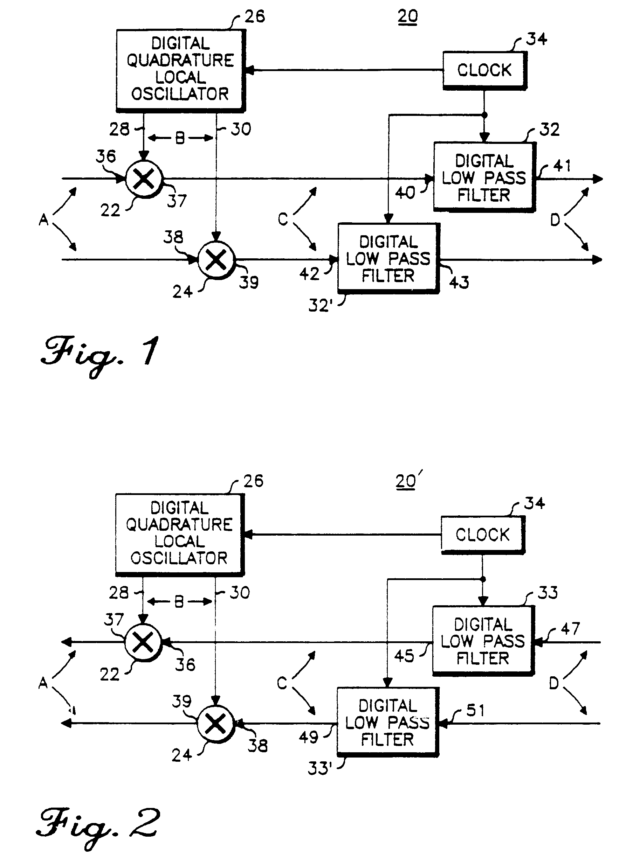

Referring now to Figure 1, a digital zero-IF selectivity section (DZISS) is depicted in block diagram form, which has been constructed in accordance with the present invention and, further, which is especially adapted for use in a receiver. Basically, DZISS 20 is comprised of an in-phase mixer 22, a quadrature-phase mixer 24, a digital quadrature LO 26 (providing an in-phase LO signal 28 and a quadrature phase LO signal 30), two digital lowpass filters 32 and 32' , and a clock source 34.

To employ the DZISS circuit in a receiver, identical digital information may be applied to both the in-phase mixer 22 and the quadrature-phase mixer 24 at input ports 36 and 38 respectively. Generally, ports 36 and 38 are not single lines, but are in fact multiple lines representing an L-bit digital word. The actual length of the digital word used in any given application is dependent upon many factors, including: the resolution required, the dynamic range required and the sampling frequency of the received signal. For example, a word length of 12 bits is considered to have an acceptable performance in receiving a typical radio signal sampled at 20MHz.

Mixers 22 and 24 have as a second input quadrature LO lines 28 and 30 respectively. As previously mentioned, these LO signals are not single connections, but are M-bit discrete time representations of signals that are 90° apart in phase (i.e., sine and cosine waveforms). Mixers 22 and 24 perform an arithmetic multiplication of the L-bit input word and the M-bit LO word, rounding the result to form an N-bit output word that is applied from output ports 37 and 39 (of mixers 22 and 24) to the digital lowpass filters input ports 40 and 42 respectively.

The digital word length parameters, L, M and N may be selected to yield acceptable noise performance. As the digital word is lengthened, more quantization levels are available to represent the signal. The smaller quantization increments lead to improved noise performance as is well understood in the art. This process is analogous to an analog implementation of a mixer producing sum and difference sine and cosine products in an analog mixer. However, all the aforementioned problems of an analog mixer are avoided in a digital implementation because of the perfect linearity of the mixers.

The digital word resultant from the aforementioned multiplication is applied to digital filters 32 and 32' to band-limit the received frequency spectrum. Digital filter 32 and 32' are identical in structure and may be formed from a recursive filter topology which will be hereinafter described in greater detail. Following the filtering process, the digital signals are output through ports 41 and 43 and sent on to any digital demodulating structure that may be employed. For example, it may be advantageous to effectuate digital demodulation by the use of a programmable digital signal processor (DSP).

Referring now to Figure 2, the DZISS, here configured for operation in a transmitter, is depicted in block diagram form. The digital signals to be transmitted would be applied to ports 47 and 51 of lowpass filters 33 and 33' which band-limits the spectrum of the signals and applies them to input ports 36 and 38 of mixers 22 and 24, respectively. As previously described, mixers 22 and 24 accept as a second input LO signals 28 and 30, respectively. The up-converted digital signal is output at ports 37 and 39 which may then be sent to any conventional summing circuit where the signals would be arithmetically added (binary addition) as is well known in the art. The information signal may then be converted to analog form through a D-to-A converter and transmitted by conventional means. From the foregoing discussion it should become apparent that a simple "inversion" of the input/output data flow of mixers 22 and 24 and selection of digital low pass filters are all that is required to change the DZISS topology from a receiver configuration to a transmitter configuration or vice-versa. Thus, the DZISS 20 of Figures 1 and 2 afford a simple, inexpensive and universal IF section that may be readily employed by both receivers and transmitters.

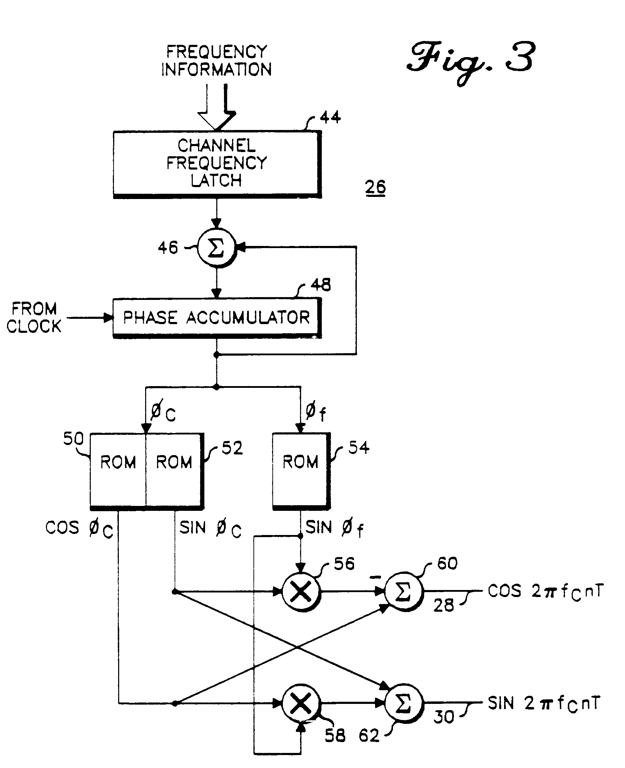

Referring now to Figure 3, digital quadrature LO 26 is depicted in block diagram form. Implementation of a DZISS hinges on the ability to generate accurate and stable discrete time representations of sine and cosine waveforms for the quadrature mixing process. Thus, the digital quadrature LO 26 is a key component of the DZISS. Traditional techniques, such as the digital feedback oscillator, use multipliers in the feedback path thereby causing a severe limitation in the operating speed of the oscillator. More advanced techniques, such as the direct ROM (read only memory) look-up approach, utilize the fact that sine and cosine waveforms can be expressed in real and imaginary parts of the unit magnitude complex phasor $e^{j2\pi f_c(nT)}$, where $f_c$ is the desired carrier frequency and $nT$ is the discrete time variable ($T$ equals the sampling period which is equal to 1/sampling rate). However, the direct ROM approach simply stores all possible phasor values which may result in large ROM requirements if the number of desired frequencies, and hence, the number of required phasors, is large. Often this large ROM requirement becomes prohibitive in a digital quadrature LO implementation due to cost and size requirements.

The disclosed invention uses a factored-ROM approach utilizing the fact that the phase angle of the unit magnitude phasor can be broken into a complex product of coarse and fine phasors. Thus, the unit magnitude phasor $e^{j\phi}$ can be represented as $e^{j\phi}c \cdot e^{j\phi}f$. Therefore, the unit magnitude phasor can be realized by having separate coarse-value phasors and fine-value phasors stored in ROM which are multiplied together to get the discrete time sine and cosine values required for the quadrature mixers. The advantage of this factorization is that the amount of ROM necessary to store the coarse-value and fine-value phasors is greatly reduced from that required of the direct ROM look-up approach. The expense paid for this ROM size reduction is the introduction of circuitry to perform the complex multiplication of coarse and fine phasors. Generally, a complex multiplication can be implemented with four multipliers and two adders. By judicious selection of the fine-value phasor, and recalling that the cosine of a small angle can be approximated by one, the ROM for the cosine fine-value phasor can be eliminated. Further, by approximating the small angle cosine values as one, two multipliers can be eliminated from the multiplication structure required to generate a complex product. This results in both a cost and size savings in the factored-ROM implementation.

Referring now to Figure 3, the digital quadrature LO 26, as implemented using the factored-ROM approach, is depicted in block diagram form. Frequency information, in the form of an M bit binary number

4

proportional to the desired frequency, is loaded into the channel frequency latch 44. Channel frequency latch 44 may be realized in many different forms. For example, assuming that M = 20, five cascaded 74LS175's (Quad D flip-flops), manufactured by Motorola, Inc., and others, provide an acceptable implementation. Those skilled in the art will appreciate that channel frequency latch 44 may be loaded by various means. For example, in a single frequency radio the channel frequency latch could be permanently loaded with a single binary number. For multiple frequency radios, channel frequency latch 44 could be loaded from an EPROM or ROM look up table or calculated and latched by a microprocessor.

The output of channel frequency latch 44 is coupled to a binary summer 46. It will be understood by those skilled in the art that the following discussion of digital quadrature LO 26, all coupling lines inbetween the functional blocks are in fact multi-bit binary words and not single connections. The output of adder 46 is coupled to phase accumulator 48. Phase accumulator 48 can be implemented as an M bit binary latch which is used to hold the address of the next location of ROM to be addressed. Thus, the output of phase accumulator 48 is coupled to cosine coarse-value ROM 50, sine coarse-value ROM 52, and sine fine-value ROM 54 (recall that fine-value cosine ROM is not required as it is being approximated by one). Further, the output of phase accumulator 48 is fed back into summer 46 to be added (modulo $2^M$) to the binary number representing the channel frequency information located in the channel frequency latch 44. The output of phase accumulator 48 is updated once every clock pulse which is generally the sampling frequency. The result of this binary addition, is that phase accumulator 48 is holding the binary sum (proportional to phase) of the last address plus a binary vector contained in the channel frequency latch. This number indicates the next address to be required to create the quadrature LO signals 28 and 30.

In actual implementation, the binary word output from phase accumulator 48 is partitioned into two segments, such that only the higher order bits of phase accumulator 48 are sent to ROM 50 and 52, and the lower order bits are sent to ROM 54. As previously stated, these bits are the addresses for the ROM locations. Upon receiving an address, ROM's 50, 52 and 54 output the digital binary word located at the received address on their respective output ports. The digital quadrature signals are then arithmetically generated from the three binary numbers.

To generate the cosine waveform (i.e., the real component of the complex waveform), the outputs of sine coarse-value ROM 52 and sine fine-value ROM 54 are first multiplied in multiplier 56. The output of multiplier 56 is fed to summing circuit 60 where it is subtracted (2's complement form) from the output of cosine coarse-value ROM 50. This arithmetic process yields the cosine-value which is output on port 28 and coupled to quadrature mixer 22 of Figure 1. To generate the sine values of the digital quadrature LO the outputs of the cosine coarse-value ROM 50 and sine fine value ROM 54 are multiplied in multiplier 58. Both multiplier 56 and 58 may be realized as, for example, an MPY016K manufactured by TRW, Inc. The output of multiplier 58 is fed to a summing circuit 62 where it is summed with the output of sine coarse-value ROM 52. Summing circuit 62 outputs via connection 30 the discrete time sine value digital word which is coupled to quadrature mixer 24 of Figure 1. Therefore, since the discrete time values of the sine and cosine signals are calculated mathematically, perfect 90° phase control is achieved using minimal ROM space.

The amount of coarse-value ROM required can be further reduced by taking advantage of symmetries in the cosine and sine waveforms, and thereby storing only the values of the unit magnitude phasor residing in the first octant (i.e., the first 45°) of the phasor unit circle. Those skilled in the art will appreciate that the unit magnitude phasor represents sine or cosine values rotating through 360°. Due to the symmetrical nature of sinusoidal waveforms, the values of the cosine and sine waveforms over the first octant of the unit circle are identical to the values of these waveforms over any other octant, except for possible sign changes and reversal of roles (i.e., sine becomes cosine and vice versa). Therefore, the only coarse-value phasors that are required are those in the first octant provided there is an indicator of which octant the phasor is currently residing, and there is circuitry present to negate (i.e., change sign) and/or exchange the outputs of coarse-cosine ROM 50 and coarse-sine ROM 52 according to the current octant. An octant indicator is readily implemented using three binary bits of the ROM address. For example, the three most-significant-bits (MSB's) could be used to indicate the octant, and the remaining bits used to address the ROM for the coarse-valued phasor.

Thus, the factored ROM LO reduces the ROM area while maintaining acceptable frequency resolution. For example, to implement a digital quadrature LO 26 that operates at 20 MHz, the coarse-value ROM's 50, 52 could each be implemented in a 32 x 16 ROM and the fine-value sine ROM 54 could be implemented in a 128 x 8 ROM. This would result in frequency resolution of approximately 600 Hz using approximately 2000 bits of ROM.

The factored-ROM configuration is preferred for operation at high sampling rates, since, except for the phase accumulator, there is no circuitry connected in a feedback manner. This allows the rest of the LO circuitry (especially multipliers 56 and 58, which represent the main speed bottleneck) to be pipelined to achieve a very high operating rate. Pipelining would consist of introducing latches at certain critical points, such as within the multipliers themselves, as is well understood in the art. Thus, a factored-ROM LO is described which outputs M-bit discrete time digital quadrature signals which exhibit a selected frequency.

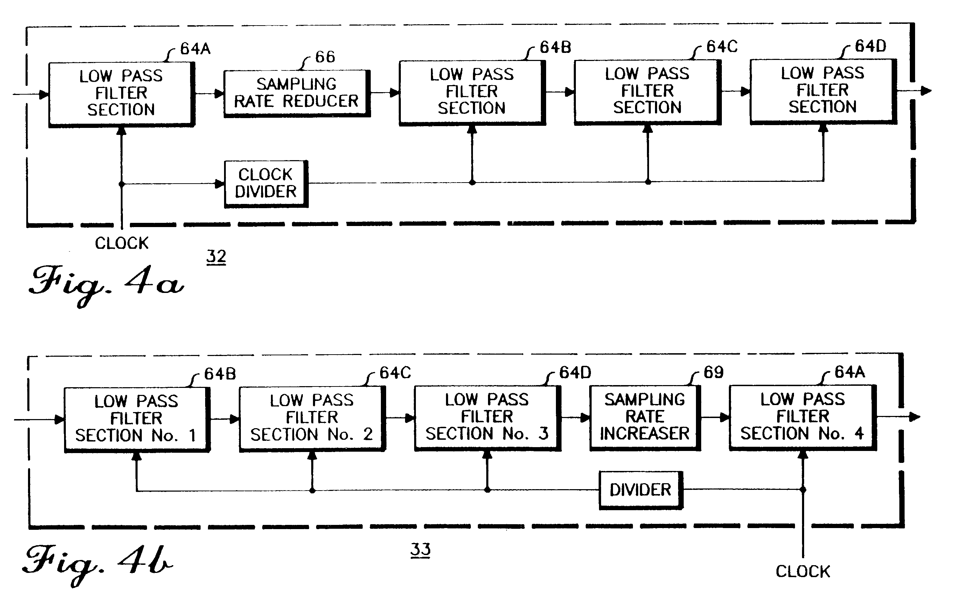

Referring now to Figure 4a, the digital lowpass filter 32 is depicted in block diagram form. Those skilled in the art will appreciate that digital filter 32 and 32' of Figure 1 are in fact identical filters and are differentiated only to facilitate the discussion of the DZISS disclosed by the present invention.

All digital filter structures are made up of basically the three same components: adders, multipliers, and delay circuits (generally latches or RAM). The factors affecting the performance of a digital filter all have to do with the fact that the various parameters of the filters are quantized, that is, they have finite precision rather than the infinite precision available in analog filters. The finite precision of a digital filter basically gives rise to three major performance effects that must be controlled in any implementation of a digital filter.

Coefficient roundoff is one of these effects. The constant valued coefficients found in a digital filter determine its frequency response. The result of rounding these coefficients so that they may be represented digitally in a finite number of bits causes a permanent, predictable change in the filter response. This is analogous to changing the RLC values in an analog filter; however, digital filters do not suffer the detriment of temperature variations as in analog filters. Generally, the higher the Q of the filter (i.e. narrow bandwidth filters compared to the sampling rate) the more the frequency response is distorted by coefficient rounding, unless special structures are employed. Judicious selection of the filter structure is of key importance in light of the fact that IF filters are generally extremely narrow band, or high-Q, filters.

Round-off noise is another of the performance characteristics that must be controlled in a digital filter. Data entering a digital filter has, of course, been rounded to a finite number of bits, and it is almost always necessary to perform additional roundings at certain points within the filter. Such rounding operations create an error or noise signal in the digital filter. For example, if the digital word length used in a filter is 16 bits and the coefficients are represented in 10 bits each multiplication operation would create a would create a 25 bit product, which must be rounded to 16 bits before the result may be put back into memory.

The last major effect that is controlled in a digital filter is the overflow level. The fact that data samples are represented in a finite number of bits means that there is a maximum allowable absolute value associated with every node in the filter which, if exceeded, results in an overflow phenomenon (generally wrap-around if 2's complement binary arithmetic is used). This largest allowed data value, coupled with the level of roundoff noise described previously, determines the dynamic range of the filter.

Several conventional structures are available to implement digital filters. A straight forward design approach is to cascade sections of first or second order direct-form filters until the desired filter order is achieved. The advantages of this method are its simplicity, regularity, and ease of actual filter design. However, the conventional approach also suffers from many detriments mostly stemming from the fact that high precision (for example 16 bit) filter coefficient representation is required to implement a narrowband filter. This necessitates highly complex multiplications (for example 16 x 20 bits) be performed in the feedback paths of the filter sections. The multiplications place severe speed and time limitations on the operation of the filters. Further, pipelining, a common technique used to speed logic circuits, cannot be employed in feedback loops. Lastly, high precision high speed multipliers consume tremendous amounts of power.

Referring now to Figure 4a, the digital lowpass filter employed in the DZISS is depicted in block diagram form. In the preferred low-speed embodiment, the digital lowpass filter 32 may be comprised of four cascaded lowpass filter sections 64a-d which are identical in topology and do not employ multipliers. Between lowpass filter section 64a and 64b is sampling rate reducer 66. Sampling rate reducer 66 may be realized in many forms. For example, if the digital word length is 24 bits, then four cascaded 74LS174's (Hex D flip-flops) manufactured by Motorola, Inc., and others, provide an acceptable implementation. Those skilled in the art will appreciate that any number of digital filter sections may be employed and that sampling rate reduction may be used between any and all filter sections. Further, filter sections having identical topologies are not required but simply facilitate the actual implementation.

High speed digital logic circuits consume high power. Therefore it is advantageous to reduce the sampling rate of the digital signal as early as possible to lower the power consumption of the sections following the sampling reduction point. The present invention brings the sampling rate reduction into the filter structure inserted immediately after the first filtering section. Further sampling rate reduction is often employed after digital lowpass filter 32 and prior to the audio demodulation section of a radio receiver.

Sampling rate reduction, commonly referred to as "decimation" in digital signal processing terminology, consists simply of discarding all but a select subset of the previous output samples. Since decimation is equivalent to resampling at a lower rate, those skilled in the art will appreciate that the bandwidth of the signal being resampled must be less than that of the higher-rate signal by an amount necessary to prevent aliasing. Decimation is generally desirable because a given subsequent operation may often be realized with less circuitry if it operates at a lower speed. Further, for CMOS (complementary metal-oxide semiconductor) technology power consumption is reduced at lower operating speeds. The narrowband digital filters 32 and 32' of the present invention thus permit all subsequent circuitry to operate at an advantageously reduced rate.

Referring now to Figure 4b, taken in conjunction with Figure 4a, the digital low-pass filter of Figure 2 is depicted in block diagram form. Basically, digital lowpass filter 33 is formed by rearranging digital lowpass filter 32 of Figure 4a. However, the sampling rate is increased in a transmitter. Accordingly, sampling rate increaser 69 is disposed between digital lowpass filter sections 64D and 64A to provide low-speed operation until the final filtering section thereby minimizing power consumption. Sampling rate increaser 69 may be implemented as sample and hold circuits which output the same sample continuously until a next sample is received. This "interpolation" process can increase the sampling frequency of a digital signal N times by repeating the held sample N-1 times until the next sample is received. Interpolation does introduce sin(x)/x distortion however, in practice, this may be easily removed through equalization in previous audio processing stages as is well known in the art.

Referring now to Figure 5, a digital lowpass filter section 64 is depicted in block diagram form. The filter employed in the DZISS is a recursive filter (i.e., the output signal is feedback, scaled, and summed at strategic points in the filter structure) having a narrow bandwidth and optimized for high-speed and low-sensitivity to the previously described detrimental effects of parameter quantization on digital filters.

Basically, the digital lowpass filter 64 consists of 4 adders (2's complement) 68a-d, 2 digital latches 70a-b and 2 binary shifters 72a-b. As mentioned previously in the discussion of the digital quadrature LO 26, the individual connections of lowpass filter 64 as described in Figure 5 are multi-bit digital words and not single electrical lines. The input signal is applied to the input of subtracting circuit 68a. A second input to subtractor 68a is taken from digital latch 70b which is fed back from the output of the filter circuit. The difference (2's complement) result of subtractor 68a is next applied to the input of bit shifter 72a which presents the shifted first sum signal as one input of summer 68b.

Bit shifter 72a shifts all bits of the data word outputted from subtractor 68a to the right (i.e., toward the least significant bit) by $N_a$ bits, effecting multiplication by a coefficient equal to $2^{-N_a}$. This bit shift may be implemented by an appropriate routing of the data lines from sub tractor 68a to adder 68b. Thus, high operating speed of digital filter section 64 is facilitated, since there is no time delay associated with bit shifter 72a, as there would be in a coefficient multiplication implemented by a conventional multiplier circuit.

Summer 68b adds to the shifted first sum signal the last output of summer 68b as held in latch 70a. Further, the last or previous output of summer 68b is applied to subtractor 68c. A second input to subtractor 68c is taken from digital latch 70b which, as previously mentioned, is taken from the output of the digital filter. The result of subtractor 68c is applied to bit shifter 72b which is coupled to summer 68d. Bit shifter 72b shifts all bits of the data word outputted from subtractor 68c to the right by $N_b$ bits, effecting multiplication by a coefficient equal to $2^{-N_b}$. Bit shifter 72b also facilitates high operating speed since no time delay is incurred. The parameters $N_a$ and $N_b$ associated with bit shifters 72a and 72b, respectively, control the frequency response of digital filter section 64, and may be chosen to yield the response appropriate to the intended application. Summer 68d adds the second shifted sum signal to the previous output of 68d as held in latch 70b. The output of latch 70b is also the output of the digital lowpass filter section 64 and represents a band-limited representation of the input signal that was previously applied to the input of summing circuit 68a.

From the foregoing discussion, those skilled in the art will appreciate that while multiplerless digital filters greatly increase the operating speed of the DZISS, the digital filters remain the predominate limitation on the DZISS operating speed. Accordingly, the present invention employs decimation immediately after the first filter section (see Figure 4a). However, decimation provides relief only to subsequent logic sections. Clearly, the first filter section must operate at a substantially higher data rate. Depending on the actual application, this operating speed burden on the first filter section may not be detrimental. However, in those applications where operating speed is a critical parameter, a need exists to relieve the burden of the first filter section, and thus, provide reliable high-speed operation.

Accordingly, in the preferred high-speed embodiment, the present invention employs a "decomposed" first digital filter section. Filter decomposition techniques have been discussed, for example, by M. Bellanger, G. Bonnerot and M. Coudreuse in a paper entitled "Digital Filtering by Polyphase Network: Application to Sample-Rate Alteration and Filter Banks", IEEE Transactions on Acoustics, Speech, and Signal Processing, Vol ASSP-24, No. 2, April 1976.

Referring now to Figure 6, an exemplary magnitude verses frequency plot of digital low pass filter section 64 is graphically depicted. As illustrated in Figure 6, digital low-pass filter section 64b provides a very narrow pass-band (several kHz), and a stop-band extending to 10MHz. As with any digital filter, the response for fs/2 to fs (where fs is the sampling frequency) is the mirror image of that from zero hertz to fs/2 (here from 0 to 10 MHz). Thus, this example assumes a digital low pass filter operating at 20 MHz band-limiting a signal centered at zero Hertz.

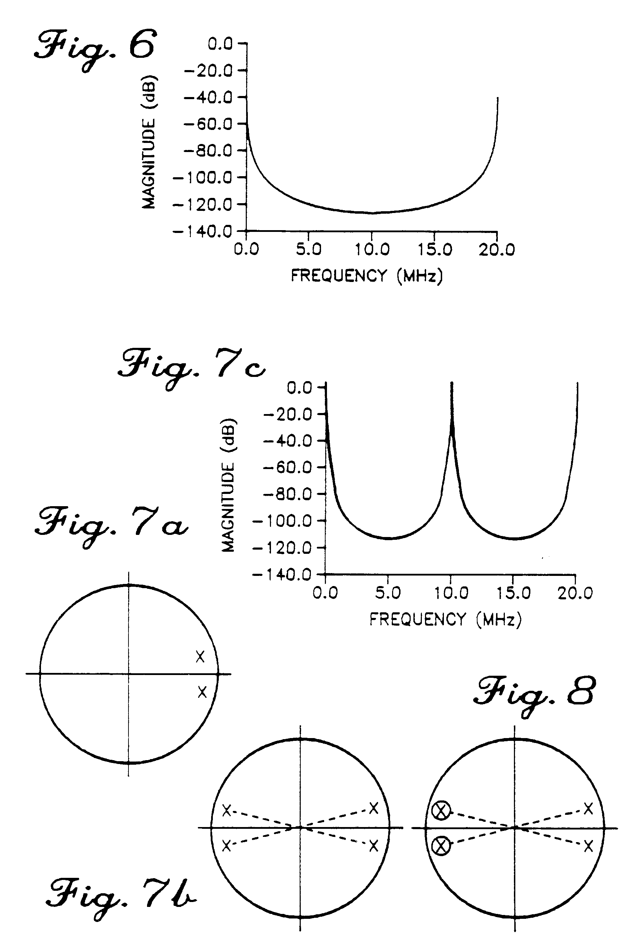

Referring now to Figures 7a-b, the decomposition technique is graphically illustrated showing the "poles" and "zeros" of the z-transform of the filter's transfer function positioned in the unit circle in the z-plane. Figure 7a shows two poles representing the filter response described previously in Figure 6. The following description pertains to decomposition by a factor of two. Those skilled in the art will appreciate that other factors are possible. The original filter may be decomposed into two or more decomposed sections that will subsequently operate at a lower speed. The first step is to split the original filter into two substantially identical filters by projecting the two poles through the origin as shown in Figure 7b. The filter magnitude verses frequency plot associated with Figure 7b is shown in Figure 7c. The decomposed filter of Figure 7c may operate approximately half as fast as the filter of Figure 6 thus effectuating a fifty percent reduction in operating speed.

Examination of the filter responses in Figures 6 and 7c reveals that the reduced operating speed has modified the filter response. Those skilled in the art will appreciate that this change is caused by the introduction of the two additional poles in the transfer function as graphically illustrated in Figure 7b. Thus, it is necessary to compensate for the two additional poles if the original response is to be recovered.

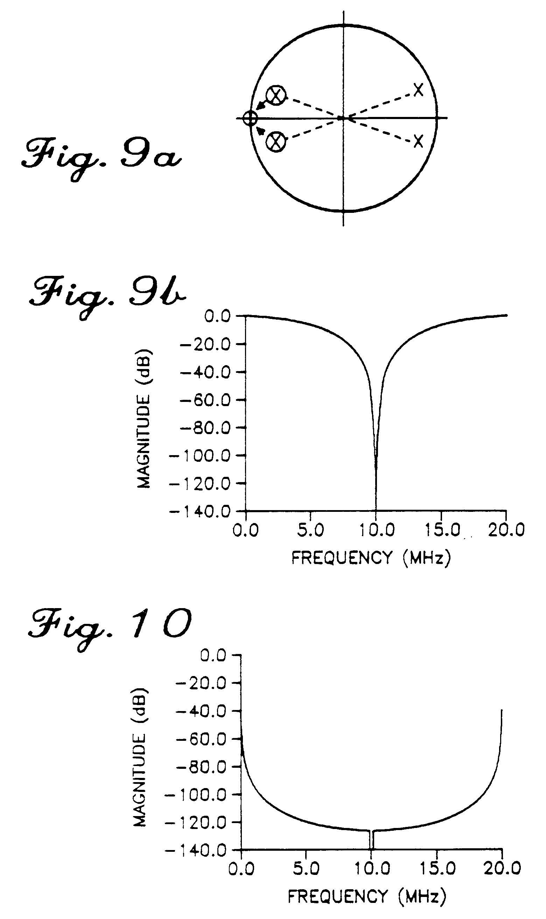

Referring now to Figure 8, the generally accepted compensation technique is graphically depicted. Basically, the two poles added to decompose the original filter are "covered" (compensated for) by two corresponding zeros. Those skilled in the art will appreciate that adding two poles and corresponding zeros to any filter transfer function does not change the actual filter response, and therefore, the decomposed filter sections (now having four poles and two zeros) will have the same filter response as the original high speed filter section as shown in Figure 6. However, the present invention deviates from this generally accepted technique to achieve a practical implementation while contemporaneously achieving acceptable performance.

Referring now to Figures 9a-b the combining (compensating) technique employed in the present invention is graphically depicted. Departing from traditional practice, the present invention relocates the compensation zeros on the unit circle equidistant from the poles to be compensated at the point $Z = -1$ in the Z-plane. The predominant reasoning for this is that by positioning the two zeros at this point the coefficients of the compensating filter become 1, 2 and 1. That is, they become simple powers of two which can be implemented by the shifting technique previously described in conjunction with shifters 72a and 72b of Figure 5.

Those skilled in the art will appreciate the ease of realization and high operating speed capability of a digital filter possessing power of two coefficients. The filter response associated with the two unit-circle zeros is graphically depicted in Figure 9b. It should become apparent that in departing from an exact pole covering the reconstructed filter response will be somewhat modified.

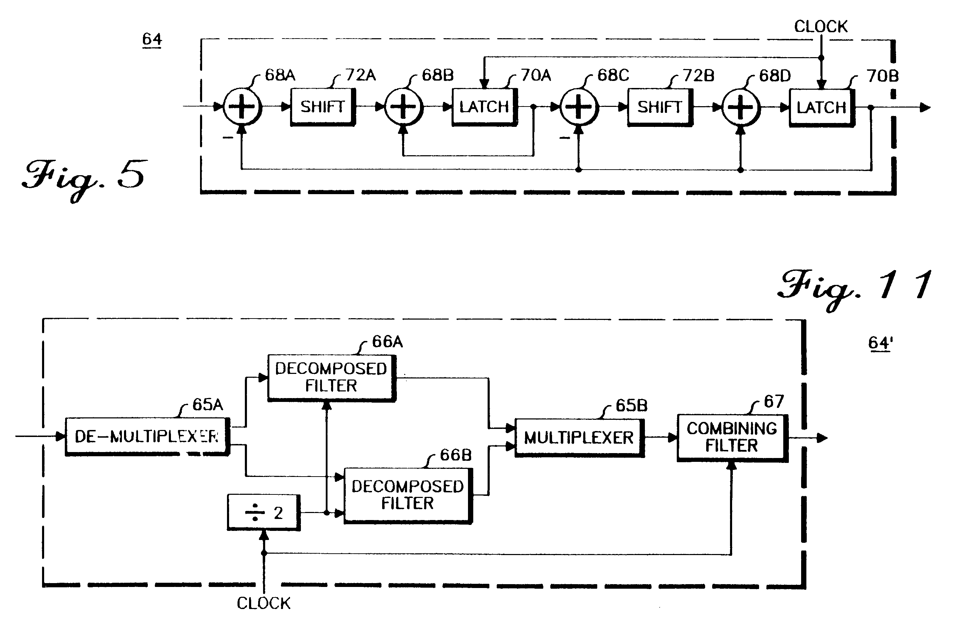

Referring now to Figure 10, the reconstructed filter response is shown. The unit circle relocation of the compensating zero creates a response imperfection at 10 MHz (see Figure 10 viewed in conjunction with Figure 6). In practice however, this imperfection is not significant and, as previously mentioned, affords a more readily realizable implementation of the combining filter.

Referring now to Figure 11, in conjunction with the foregoing discussion and Figures 6-10, the decomposed filter structure is shown. A high speed multi-bit digital signal is applied to digital low-pass filter section 64' at the input to demultiplexer 65a. Demultiplexer 65a has two output ports to which route the input digital words in a alternating manner. Thus, since only every other digital word is present on either output port of demultiplexer 65a, the output data rate is one-half the input data rate. The data words are coupled to decomposed digital filters 66a and 66b which operate in parallel. Therefore, in each branch of low pass filter section 64', two poles of filtering are employed, however, the operating speed has been reduced by fifty percent.

After being filtered, the digital words are combined into a filtered version of the input data stream by multiplexer 65b. Thus, multiplexer 65b outputs a signal at the original input data rate. As previously discussed the combined filtered data words must pass through compensating or combining filter 67 so that the overall response of low pass filter section 64' is substantially the same as low pass filter section 64 of Figure 4a.

It should be apparent that combining filter 67 operates at a higher data rate. Although facially this may appear inconsistent with the purpose of filter decomposition, recall from the foregoing discussion that the filter coefficients of combining filter 67 are simple powers of two by virtue of the filter zero placement on the unit circle (see Figure 9a). Therefore, the filter actually realized requires less circuitry due to the resulting coefficients, and thus, can readily operate at substantially twice the data rate of the original low pass filter section 64. Thus, the unit circle placement balances the need for an appropriate filter response and a practical filter realization.

Digital low pass filter section 64' can be readily used in place of section 64 to provide a higher speed embodiment of DZISS 20. Generally, decimation is employed immediately after the first digital low pass filter section 64a (see Figure 4a) and accordingly, subsequent sections need not be decomposed provided an appropriate decimation rate is employed. The decomposition technique as embodied in digital filter section 64' affords an increase in operating speed capability of approximately 2-to-1. Those skilled in the art will appreciate that more extensive decompositions are possible (e.g., four parallel sections rather than two), which would allow even higher operating speed. Thus, a tradeoff between operating speed and circuit complexity is made possible with this decomposition technique.

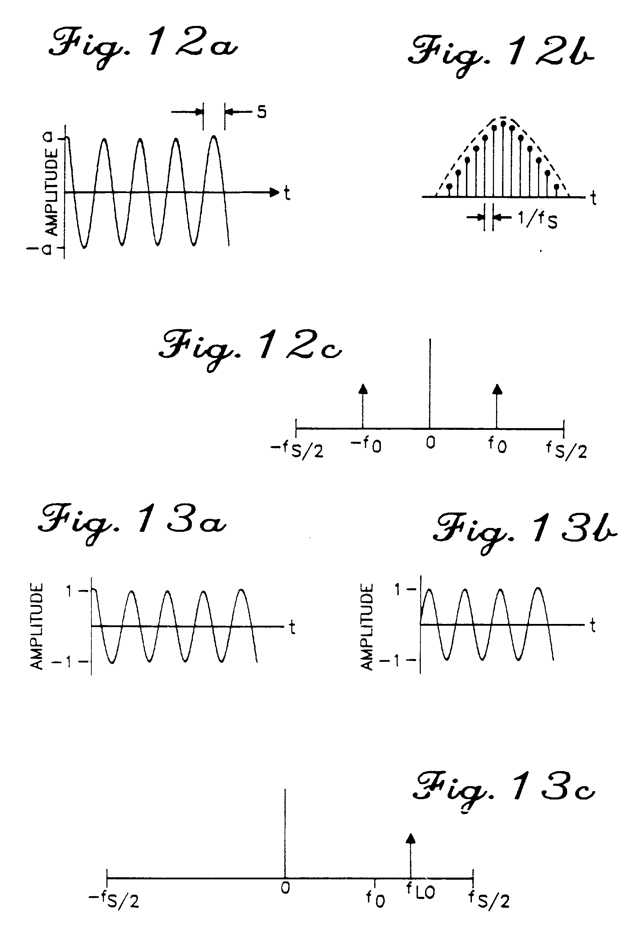

As an example of the operation of the DZISS, the following discussion describes the demodulation of a tone transmitted to a receiver having a DZISS. Referring now to Figures 12a-c in conjunction with Figure 1, an input waveform is shown as a function of time in Figure 12a. This waveform would be applied to both input ports 36 and 38 of quadrature mixers 22 and 24. Although appearing as a continuous analog sinusoid, the waveform in Figure 12a is actually a series of discrete time finite amplitude samples as illustrated in Figure 12b. Figure 12b is an exploded time segment taken along the line 5-5 of Figure 12a. Thus, Figure 12b illustrates a portion of these discrete amplitude samples which occur at a spacing of $1/f_s$ (where $f_s$ is the sampling frequency). Figure 12c illustrates the frequency spectrum (magnitude only) associated with the waveform of Figure 12c. The frequency spectrum of the signal appears within the band-limited frequency region of $\pm f_s/2$ as seen in Figure 12c.

Referring now to Figure 13a-c in conjunction with Figure 1, the digital quadrature LO signals are presented as a function of time and frequency. Figure 13a depicts cosine signal 28 which is provided from digital quadrature LO 26. As in Figure 12, Figure 13a is actually a series of finite amplitude samples closely spaced at $1/f_S$. Sine waveform B, generated from digital quadrature LO 26 is seen in Figure 13b. These two waveforms constitute the complex waveform of the LO signal wherein the real component is the cosine waveform and the imaginary component is the sine waveform. The frequency spectrum of this complex waveform is depicted in Figure 13c.

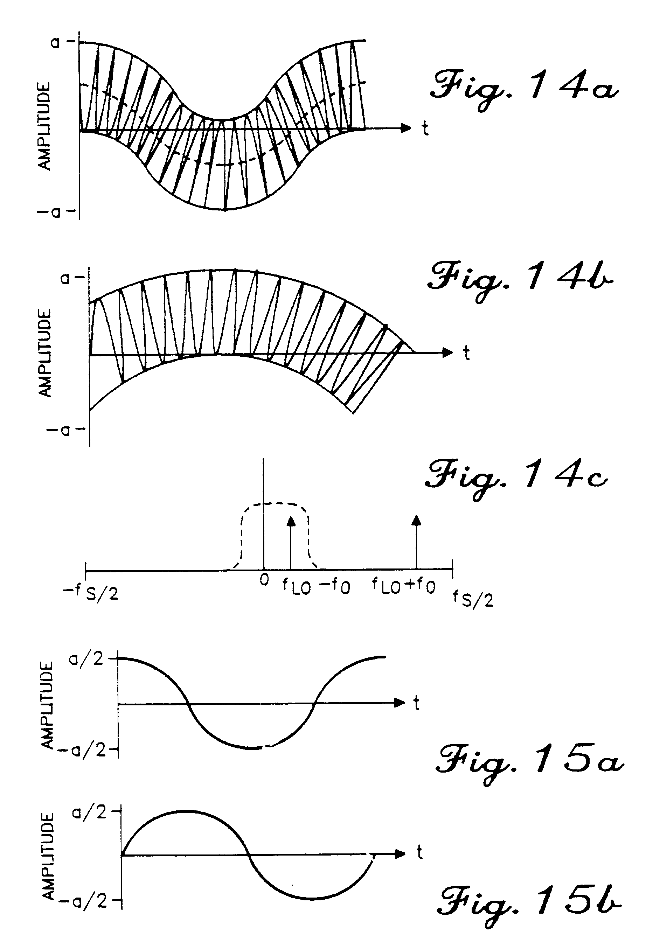

Referring now to Figures 14a-c taken in conjunction with Figure 1, the signal waveforms at point C of Figure 1 are depicted. Figure 14a depicts, as a function of time, the output of in-phase mixer 22. Figure 14b depicts the time domain information signal from quadrature-phase mixer 24. Those skilled in the art will appreciate that each component contains a sum and difference frequency. The LO frequency is selected such that the difference frequency falls within the pass-band of digital low-pass filters 32 and 33. As previously mentioned, although appearing continuous in nature, the waveforms of Figure 14a and 14b are in fact discrete amplitude pulses. The frequency spectrum associated with these waveforms is depicted in Figure 14c. Figure 14c illustrates the spectrum of Figure 12c which has been shifted by the frequency of $f_{LO}$. Figure 14c also contains a dashed representation of the passband response of the digital lowpass filters 32 and 33 to which the Figures of 14a and 14b are next applied.

Referring now to Figures 15a-c taken in conjunction with Figure 1, the output waveforms of the digital lowpass filters 32 and 32' are depicted as they would be seen at reference point D of Figure 1. The digital lowpass filters have removed the higher sum frequency component of Figure 14c and have passed only the $f_{LO} - f_o$ signal. Again, these signals are in fact discrete amplitude pulses and not continuous waveforms. As can be seen in Figures 15a and 15b the recovered signals are still in phase quadrature at reference point D. These signals are now passed through output ports 40 and 42 to whatever audio demodulation section that may be employed in the receiver. The complex frequency spectrum associated with the signals of Figures 15a and 15b is depicted in Figure 15c.

A mathematical representation of the transmitted tone demodulation of Figures 12-15, is expressed below in terms of the unit magnitude phaser. The real and imaginary components of the unit magnitude phaser are expressed in terms of sine and cosine waves. A simple transmitted tone applied to point A can be represented as follows:

$$A(t) = a \cos 2\pi f_o t$$
$$= a/2 \, (e^{j2\pi f_o t} + e^{-j2\pi f_o t})$$

This signal is applied to quadrature mixers 22 and 24, together with the digital quadrature LO signals 28 and 30 respectively. The digital quadrature LO signal, a complex waveform, can be expressed mathematically as follows:

$$B(t) = e^{j2\pi f_{lo}t}$$
$$= \cos 2\pi f_{lo}t + j\sin 2\pi f_{lo}t$$

The multiplication product output of mixers 22 and 24 is applied to digital lowpass filters 32 and 32'. The signals represented at point C can be represented as follows:

$$C(+) = a/2[e^{j2\pi(f_{lo}+f_o)t} + e^{j2\pi(f_{lo}-f_o)t}]$$
$$= a/2[\cos 2\pi(f_{lo}+f_o)t + \cos 2\pi(f_{lo}-f_o)t]$$
$$+ j\,a/2\,[\sin 2\pi(f_{lo}+f_o)t + \sin 2\pi(f_{lo}-f_o)t]$$

Lastly, the output waveform present at terminals 40 and 42 can be represented as follows:

$$D(t) = a/2\,e^{j2\pi(f_{lo}-f_o)t}$$
$$= a/2\,\cos 2\pi(f_{lo}-f_o)t + j\,a/2\,\sin 2\pi(f_{lo}-f_o)t$$

Thus, the demodulation of a transmitted tone received by a receiver employing a DZISS section has been described both graphically and mathematically.

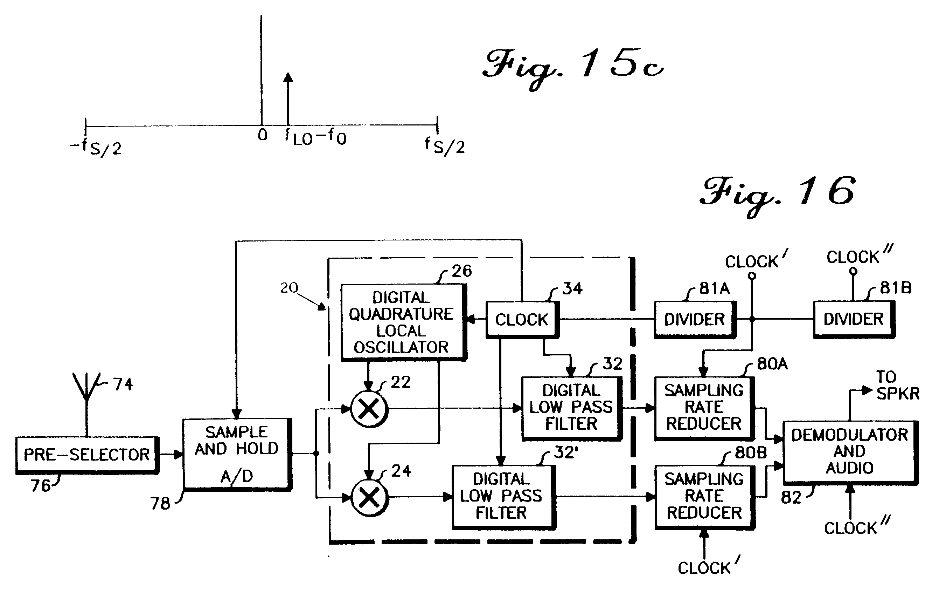

Referring now to Figure 16, an exemplary block diagram of a receiver employing a DZISS is shown. Basically, the received radio frequency signal would be detected on the antenna 74 and presented to preselector 76. Preselector 76 comprises an amplifier and a bandpass filter which may be implemented as a helical or ceramic filter as is well known in the art. The band-limited signal from preselector 76 is next applied to sample and hold circuit 78. Sample and hold 78 may also perform the function of converting the received analog signal into digital form. Those skilled in the art will appreciate that this function may be implemented in separate blocks of a sample and hold followed by a conventional A to D; however, for the purposes of this illustration they can be considered to be one in the same.

In addition to the speed limitations previously described for lowpass filters 32 and 32' , the operating speed of sample and hold (and A-to-D) 78 will determine the maximum speed of the receiver (i.e. the faster the sample and hold circuit 78 can operate the higher the frequency bandwidth of the receiver). The output of sample and hold circuit 78, although represented as a single line, is in fact a multi-bit digital word as previously described in conjunction with various sections of DZISS 20. These signals are split (identically) and applied to quadrature mixers 22 and 24 and the DZISS circuit operates, as previously described, to output a band-limited recovered signal centered at zero Hz.

The output signal is applied to sampling rate reducers 80a and 80b to lower the sampling rate, and hence the required power consumption of the following circuitry. This decimation process is also performed in digital lowpass filters 32 and 32' as previously described. Once the sampling rate has been lowered to an acceptable level (for example from 100 MHz to 100 kHz), the signals, still in phase quadrature, are applied to demodulation and audio recovery circuit 82. Demodulation and audio circuit 82 can be implemented in one of many known techniques and in particular may be a programmable digital signal processor (DSP) as is well known in the art. The output of demodulation and audio circuit 82 may then be applied to an audio power amplifier and speaker to present the recovered audio to the receiver operator. Thus, a digital receiver employing the DZISS of the present invention is described.

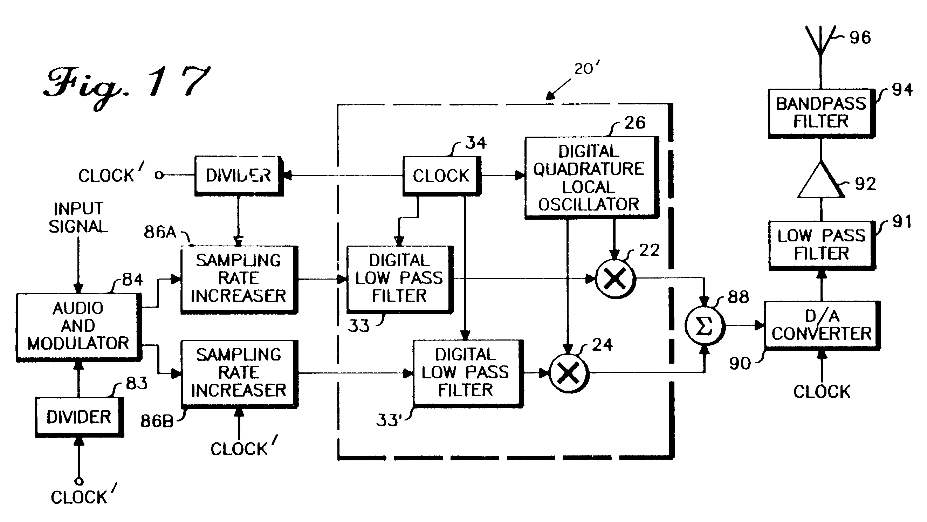

Referring now to Figure 17, an illustrative block diagram of a transmitter employing the DZISS of the present invention is shown. Basically, an input signal is applied to audio and modulator circuit 84. The input signal may be a voice signal. If so, audio and modulator circuit 84 may include an analog-to-digital converter. Conversely, the voice may have been previously converted to digital form prior to the audio and modulator block 84 eliminating the A-to-D requirement. Alternatively, the input signal may already be in digital form if it were generated, for example, by a voice synthesis circuit. A further function of audio and modulation block 84 is to split the audio signal into quadrature paths. These quadrature paths are applied separately to sampling-rate increasing circuits 86a and 86b. The increased sampled signal is now applied to digital lowpass filters 33 and 33' respectively. The filters band-limit the digital signals in the same manner as previously described in conjunction with Figure 2.

The band-limited signals are now applied to quadrature mixers 22 and 24 in addition to the quadrature LO signals from digital quadrature LO 26. The output signals of quadrature mixers 22 and 24 are summed (2's complement) in summing circuit 88 and applied to D-to-A circuit 90. The output of D-to-A 90 consists of a series of discrete finite-width amplitude pulses, which are smoothed into a continuous waveform by lowpass filter 91, which is coupled to the output port of D-to-A 90. The output of low pass filter 91, now a continuous analog signal, is applied to power amplifier 92 to have the signal power increased by an appropriate amount depending predominantly upon the required range of the transmitter. The amplified signal is again band-limited by bandpass filter 94 to transmit only that portion of the spectrum that contains the information signal and not pollute the surrounding spectrum. The band-limited signal is broadcast through antenna 96 as is well understood in the art. Thus a transmitter employing the DZISS of the present invention is described wherein the digital signal is converted back to analog form immediately prior to transmission.

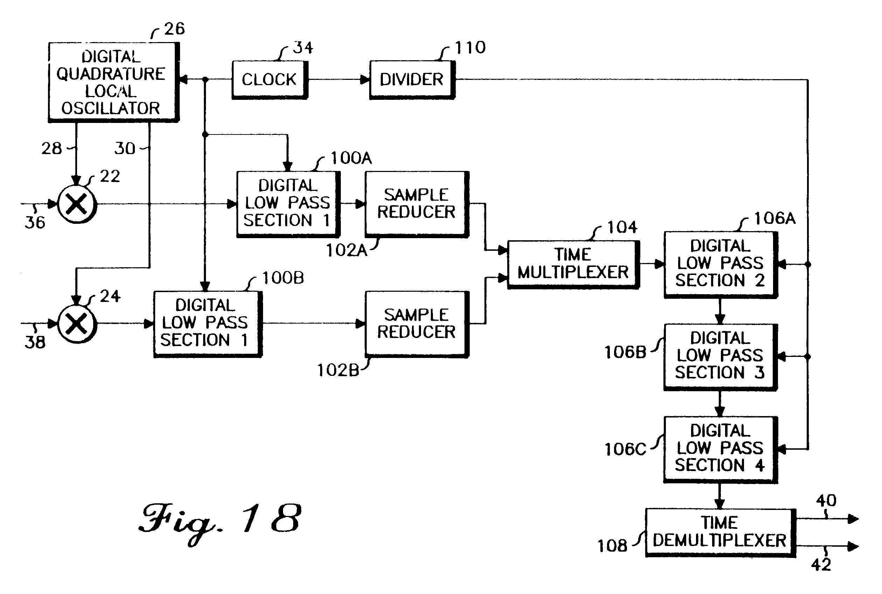

Referring now to Figure 18, an alternate embodiment of the DZISS for use in a receiver is depicted in block diagram form. As previously described, the input signal applied to connections 36 and 38 are applied as a first input to multipliers 22 and 24. A second input to quadrature mixers 22 and 24 are the digital quadrature LO signals 28 and 30, respectively. The N-bit multiplied products of mixers 22 and 24 are next applied to a single section of the digital lowpass filter previously described in Figure 5. Digital lowpass sections 100a and 100b provide two poles of filtering to each quadrature path by either the high-speed realization as shown in Figure 11 or as embodied in Figure 5 for lower data rates. After passing through filter sections 100a and 100b, the digital words are communicated to sampling rate reducers 102a and 102b respectively. The outputs of sampling rate reducers 102a and 102b are now applied to and 102b are now applied to time multiplexing circuit 104.

Basically, if the sampling rate is reduced by an appropriate amount, the last three sections of the digital lowpass filter can be time shared since there is so much time available between samples from the high speed section to the low-speed sections. This represents a significant cost and size savings in that three second order digital lowpass filter sections need not be implemented. Since digital lowpass sections 106a-c process lower speed digital information, the clock speed driving then must be appropriately lowered. Therefore, clock 34 is applied to divider 110 to lower (by an amount comparable to sampling rate reducer 102a and 102b) the clock speed so that synchronization can be maintained.

The output of filter section 106c is a band-limited digital signal of N bits identical to the signals at 40 and 42 of Figure 1 (although they are time multiplexed). The output of filter section 106c is applied to time demultiplexing circuit 108 which separates the signals back into their original quadrature paths (although they are now appropriately band-limited), and outputs them on output ports 40 and 42 respectively. Thus, by choosing an appropriate decimation rate a significant cost and space savings for implementing the DZISS of the present invention is disclosed.

## Claims

1. A digital zero-IF selectivity section circuit operating on a recovered input signal in a receiver device, comprising, in combination:

   clock means (34) for providing a periodic clock signal;

   digital oscillator means (26), coupled to said clock means, for providing first and second digitized discrete-time signals, such that said first digitized discrete time signal leads said second digitized discrete time signal by 90 degrees in phase;

   means (22, 24) for digital quadrature mixing the input signal and said first and second digitized discrete time signals to provide first and second digitized output signals occupying a selected frequency band centered substantially at zero Hertz; and

   first (32) and second (32') digital filtering means coupled to said clock means and to said digital quadrature mixing means for selectively band-limiting the frequency spectrum of said first and second digitized output signals thereby providing first and second filtered digitized output signals,

   characterised in that each of these filtering means comprises:

a decomposed, internally multiplexed, filter section (64) coupled to said digitized output signals;

sample rate reducing means (66) coupled to said decomposed filter section; and

a multiplierless digital filter section (64B, 64C, 64D) coupled to said sample rate reducing means.

2. A digital zero-IF selectivity section circuit operating on a recovered input signal in a transmitter device, comprising, in combination:

clock means (34) for providing a periodic clock signal;

digital oscillator means (26), coupled to said clock means, for providing first and second digitized discrete-time signals, such that said first digitized discrete time signal leads said second digitized discrete time signal by 90 degrees in phase;

first and second digital filtering means (33, 33') coupled to said clock means and to said input signal for selectively band-limiting the frequency spectrum of said first and second input signals thereby providing first and second filtered input signals;

means (22, 24) for digital quadrature mixing said first and second filtered input signals and said first and second digitized discrete time signals to provide first and second digitized output signals occupying a selected frequency band centered substantially at zero Hertz; and

characterised in that each of these filtering means comprises:

a decomposed, internally multiplexed, filter section (64) coupled to said digitized input signals;

sample rate increasing means (69) coupled to said decomposed filter section; and

a multiplierless digital filter section (64B, 64C, 64D) coupled to said sample rate increasing means,

3. The circuit of claim 1 or claim 2, wherein said decomposed, internally multiplexed filter section comprises:

means for generating a second periodic clock signal wherein said second clock signal has a period approximately equal to at least twice the period of said first clock signal;

demultiplexing means (65A), coupled to said digitized output signals for demultiplexing same into at least two demultiplexed signals;

first filtering means (66A, 66B) for filtering said demultiplexed signals providing at least two filtered demultiplexed signals;

multiplexing means (65B) for multiplexing said filtered demultiplexed signals into a multiplexed signal which represents a selectively band-limited portion of said input signal; and

second filtering means (67) coupled to said first clock signal and said multiplexed signal for providing a combined and filtered multiplexed output signal which represents a selectively band-limited portion of said digitized output signals.

4. The circuit of claim 1, 2 or 3 wherein each of said multiplierless digital filter sections comprises:

first binary summing means (68A) coupled to an input signal and a second binary delayed signal for providing a first binary sum signal;

first binary shifting means (72A) coupled to said first binary sum signal for providing a shifted first binary sum signal;

second binary summing means (68B) coupled to said shifted first sum signal and a first binary delayed signal for providing a second binary sum signal;

first binary storage means (70A) coupled to said second binary sum signal for providing said first binary delayed signal;

third binary summing means (68C) coupled to said first binary delayed signal and said second delayed binary signal for providing a third binary sum signal;

second binary shifting means (72B) coupled to said third binary sum signal for providing a shifted third binary sum signal;

fourth binary summing means (68D) coupled to said shifted third binary sum signal and said second binary delayed signal for providing a fourth binary sum signal;

second binary storage means (70B) coupled to said fourth binary sum signal for providing said second binary delayed signal.

5. The circuit of claim 4, wherein said second binary delayed signal comprises the digital filter output signal.

6. The circuit of any one of the preceding claims, wherein each of said first and second digital filtering means further comprises:

at least two digital filter sections cascaded together for achieving a selected order digital filter and intercoupled by sampling rate increasing means, for reducing the operating speed of subsequent logic sections.

7. A digital zero-IF selectivity section for operating on a received input signal in a receiver, comprising, in combination:

clock means (34) for providing at least a first and second periodic clock signal;

digital oscillator means (26), coupled to said clock means, for providing first and second digitized discrete-time signals such that said first digitized discrete-time signal leads said second digitized discrete time signal by 90 degrees in phase;

means (22, 24) for digital quadrature mixing the input signal and said first and second digitized signals for providing first and second digitized output signals such that said first and second digitized output signals occupy a selected frequency band centered substantially at zero Hertz;

first (100A) and second (100B) digital filtering means coupled to said clock means and to said digital quadrature means for providing first and second filtered digitized output signals, characterised in that each of said first and second digital filtering means comprises at least one digital filtering section (64, 64') coupled to a sample rate reducing means (66, 102A, 102B), ;

time multiplexing means (104) are provided coupled to said first and second digital filter means to provide a multiplex output signal;

further digital filtering means (106), are provided coupled to said multiplex means, comprising at least one digital filtering section, coupled to said clock means, for providing a selected order filter and to provide a filtered multiplex signal; and

time demultiplexing means (108) are provided coupled to said clock means and said filtered multiplex signal for providing first and second output signals such that said first and second output signal occupy a frequency band substantially centered at zero Hertz.

8. A digital zero-IF selectivity section according to claim 7 further comprising:

means for dividing the frequency of said clock signal to provide a second clock signal;

wherein said further digital filtering means (106) comprises:

third digital filtering section means (106A) coupled to said second clock signal and said multiplex output signal to provide a first filtered multiplex signal;

fourth digital filtering section means (106B) coupled to said second clock signal and first filtered multiplex signal to provide a second filtered multiplex signal; and

fifth digital filtering section means (106B) coupled to said second clock signal and second filtered multiplex signal to provide a third filtered multiplex signal.

9. The circuit of any one of the preceding claims wherein said digital oscillator means further comprises:

binary addressing means having an input port for receiving a frequency information signal and an additional input port coupled to said clock means to provide a binary address signal;

binary storage means coupled to said binary addressing means for providing a plurality of stored binary signals; and

combining means constructed and arranged to combine said stored binary signals for providing said first and second digitized discrete-time signals.

10. The circuit of claim 9, wherein said binary addressing means includes a first and second binary storage means comprised of a plurality of single bit storage means.

11. The circuit of claim 9 or 10, wherein said binary storage means comprises read-only-memory.

12. The circuit of any one of the preceding claims, wherein said digital quadrature mixing means (22, 24) further comprises:

first (22) and second (24) discrete mixing means each coupled respectively to said first and second input signals and a respective one of said first and second digitized discrete-time signals to provide said first and second digitized output signals.

13. The circuit of claim 12, wherein said first and second mixing means comprise digital multipliers (56, 58).

**EP 0 216 803 B1**

**Patentansprüche**

**1.** Digitale Null-ZF-Trennschärfenabschnittsschaltung, die ein wiedergewonnenes Eingangssignal in einer Empfängervorrichtung bearbeitet, und in Kombination aufweist:

eine Takteinrichtung (34) zur Bereitstellung eines periodischen Taktsignals;

eine an die Takteinrichtung gekoppelte digitale Oszillatoreinrichtung (26), zur Bereitstellung eines ersten und eines zweiten digitalisierten diskreten Zeitsignals, so daß das erste digitalisierte diskrete Zeitsignal dem zweiten digitalisierten diskreten Zeitsignal in der Phase um 90° voreilt;

eine Einrichtung (22, 24) zur digitalen Quadraturmischung des Eingangssignals und des ersten und zweiten digitalisierten diskreten Zeitsignals zur Bereitstellung eines ersten und eines zweiten digitalisierten Ausgangssignals, welches ein ausgewähltes Frequenzband einnimmt, das im wesentlichen bei Null Hertz zentriert ist; und

eine erste (32) und eine zweite (32') digitale Filtereinrichtung, die an die Takteinrichtung und an die Quadraturmischeinrichtung gekoppelt sind, um digital selektiv eine Bandbegrenzung des Frequenzspektrums des ersten und zweiten digitalisierten Ausgangssignals durchzuführen und hierdurch ein erstes und ein zweites gefiltertes digitalisiertes Ausgangssignal zur Verfügung zu stellen, dadurch gekennzeichnet, daß jede dieser Filtereinrichtungen umfaßt:

einen zerlegten, intern gemultiplexten Filterabschnitt (64), der an die digitalisierten Ausgangssignale angekoppelt ist;

eine Abtastratenreduziereinrichtung (66), die an den zerlegten Filterabschnitt angekoppelt ist; und

einen keinen Multiplizierer aufweisenden digitalen Filterabschnitt (64B, 64C, 64D), der an die Abtastratenverringerungseinrichtung gekoppelt ist.

**2.** Digitale Null-ZF-Trennschärftenabschnittsschaltung, die ein wiedergewonnenes Eingangssignal in einer Empfängervorrichtung bearbeitet, und in Kombination umfaßt:

eine Takteinrichtung (34) zur Bereitstellung eines periodischen Taktsignals;

eine an die Takteinrichtung gekoppelte digitale Oszillatoreinrichtung (26) zur Bereitstellung eines ersten und eines zweiten digitalisierten diskreten Zeitsignals, so daß das erste digitalisierte diskrete Zeitsignal dem zweiten digitalisierten diskreten Zeitsignal in der Phase um 90° voreilt;

eine erste und eine zweite digitale Filtereinrichtung (33, 33'), die an die Takteinrichtung und an das Eingangssignal gekoppelt ist, um selektiv eine Bandbegrenzung des Frequenzspektrums des ersten und zweiten Eingangssignals durchzuführen, um hierdurch ein erstes und ein zweites gefiltertes Eingangssignal zur Verfügung zu stellen;

eine Einrichtung (22, 24) zur digitalen Quadraturmischung des ersten und zweiten gefilterten Eingangssignals und des ersten und zweiten digitalisierten diskreten Zeitsignals zur Bereitstellung eines ersten und eines zweiten digitalisierten Ausgangssignals, welches ein ausgewähltes Frequenzband einnimmt, das im wesentlichen bei Null Hertz zentriert ist; und

dadurch gekennzeichnet, daß jede dieser Filtereinrichtungen umfaßt:

einen zerlegten, intern gemultiplexten Filterabschnitt (64), der an die digitalisierten Eingangssignale angekoppelt ist;

eine Abtastratenerhöhungseinrichtung (69), die an den zerlegten Filterabschnitt angekoppelt ist; und

einen keinen Multiplizierer aufweisenden digitalen Filterabschnitt (64B, 64C, 64D), der an die Abtastratenerhöhungseinrichtung angekoppelt ist.

**3.** Schaltung nach Anspruch 1 oder Anspruch 2, bei welcher der zerlegte, intern gemultiplexte Filterabschnitt umfaßt:

eine Einrichtung zur Erzeugung eines zweiten periodischen Taktsignals, wobei das zweite Taktsignal eine Periode aufweist, die im wesentlichen gleich zumindest dem Zweifachen der Periode des ersten Taktsignals ist;

eine Demultiplexereinrichtung (65A), die an die digitalisierten Ausgangssignale angekoppelt ist, um diese in zumindest zwei demultiplexte Signale zu demultiplexen;

eine erste Filtereinrichtung (66A, 66B) zum Filtern der demultiplexten Signale und zur Bereitstellung zumindest zweier gefilterter, demultiplexter Signale;

eine Multiplexeinrichtung (65B) zum Multiplexen der gefilterten, demultiplexten Signale in ein gemultiplextes Signal; welches einen selektiv bandbegrenzten Abschnitt des Eingangssignals repräsentiert; und

eine zweite Filtereinrichtung (67), die an das erste Taktsignal und an das gemultiplexte Signal angekoppelt ist, um ein kombiniertes und gefiltertes gemultiplextes Ausgangssignal zur Verfügung zu

14

stellen, welches einen selektiv bandbegrenzten Abschnitt des digitalisierten Ausgangssignals repräsentiert.

4. Schaltung nach Anspruch 1, 2 oder 3, bei welcher jeder der keinen Multiplizierer aufweisenden Digitalfilterabschnitte umfaßt:

eine erste binäre Summiereinrichtung (68A), die an ein Eingangssignal und ein zweites binäres verzögertes Signal gekoppelt ist, um ein erstes binäres Summensignal zur Verfügung zu stellen;

eine erste binäre Verschiebungseinrichtung (72A), die an das erste binäre Summensignal gekoppelt ist, um ein verschobenes, erstes binäres Summensignal zur Verfügung zu stellen;

eine zweite binäre Summiereinrichtung (68B), die an das verschobene erste Summensignal und ein erstes binäres verzögertes Signal gekoppelt ist, um ein zweites binäres Summensignal zur Verfügung zu stellen;

eine erste binäre Speichereinrichtung (70A), die an das zweite binäre Summensignal gekoppelt ist, um das erste binäre verzögerte Signal zur Verfügung zu stellen;

eine dritte binäre Summiereinrichtung (68C), die an das erste binäre verzögerte Signal und das zweite binäre verzögerte Signal gekoppelt ist, um ein drittes binäres Summensignal zur Verfügung zu stellen;

eine zweite binäre Verschiebungseinrichtung (72B), die an das dritte binäre Summensignal gekoppelt ist, um ein verschobenes drittes binäres Summensignal zur Verfügung zu stellen;

eine vierte binäre Summiereinrichtung (68D), die an das verschobene dritte binäre Summensignal und das zweite binäre verzögerte Signal gekoppelt ist, um ein viertes binäres Summensignal zur Verfügung zu stellen;

eine zweite binäre Speichereinrichtung (70B), die an das vierte binäre Summensignal gekoppelt ist, um das zweite binäre verzögerte Signal zur Verfügung zu stellen.

5. Schaltung nach Anspruch 4, bei welcher das zweite binäre verzögerte Signal das Digitalfilter-Ausgangssignal umfaßt.

6. Schaltung nach einem der voranstehenden Ansprüche, bei welcher jede der ersten und zweiten digitalen Filtereinrichtungen weiter umfaßt:

zumindest zwei digitale Filterabschnitte, die in Kaskadenschaltung zusammengeschaltet sind, um ein Digitalfilter ausgewählter Ordnung zu erzielen, und die durch eine Abtasterhöhungseinrichtung miteinander gekoppelt sind, um die Betriebsgeschwindigkeit nachfolgender Logikabschnitte zu verringern.

7. Digitaler Null-ZF-Trennschärfeabschnitt zur Bearbeitung eines empfangenen Eingangssignals in einem Empfänger, der in Kombination aufweist:

eine Takteinrichtung (34) zur Bereitstellung zumindest eines ersten und eines zweiten periodischen Taktsignals;

eine digitale Oszillatoreinrichtung (26), die an die Takteinrichtung gekoppelt ist, um ein erstes und ein zweites digitalisiertes diskretes Zeitsignal zur Verfügung zu stellen, so daß das erste digitalisierte diskrete Zeitsignal dem zweiten digitalisierten diskreten Zeitsignal in der Phase um 90° vorauseilt;

eine Einrichtung (22, 24) zur digitalen Quadraturmischung des Eingangssignals und des ersten und zweiten digitalisierten Signals, um ein erstes und ein zweites digitalisiertes Ausgangssignal so zur Verfügung zu stellen, daß das erste und das zweite digitalisierte Ausgangssignal ein ausgewähltes Frequenzband einnehmen, das im wesentlichen bei Null Hertz zentriert ist;

eine erste (100A) und eine zweite (100B) Digitalfiltereinrichtung, die an die Takteinrichtung und an die digitale Quadratureinrichtung gekoppelt ist, um ein erstes und ein zweites gefiltertes, digitalisiertes Ausgangssignal zur Verfügung zu stellen, dadurch gekennzeichnet, daß jede der ersten und zweiten digitalen Filtereinrichtungen zumindest einen digitalen Filterabschnitt (64, 64') aufweist, der an eine Abtastratenverringerungseinrichtung (66, 102A, 102B) gekoppelt ist;

daß Zeitmultiplexeinrichtungen (104) vorgesehen sind, die an die erste und zweite Digitalfiltereinrichtung gekoppelt sind, um ein Multiplex-Ausgangssignal zur Verfügung zu stellen;

daß an die Multiplexeinrichtung gekoppelte weitere Digitalfiltereinrichtungen (106) vorgesehen sind, die zumindest einen digitalen Filterabschnitt umfassen, der an die Takteinrichtung gekoppelt ist, um ein Filter einer ausgewählten Ordnung sowie ein gefiltertes Multiplexsignal zur Verfügung zu stellen; und

daß Zeitdemultiplexeinrichtungen (108) vorgehen sind, die an die Takteinrichtung und das gefilterte Multiplexsignal gekoppelt sind, um erste und zweite Ausgangssignale so zur Verfügung zu stellen, daß die ersten und zweiten Ausgangssignale ein Frequenzband einnehmen, das im wesentlichen bei Null Hertz zentriert ist.

**8.** Digitaler Null-ZF-Trennschärfeabschnitt nach Anspruch 7, der weiterhin umfaßt:

eine Einrichtung zur Unterteilung der Frequenz des Taktsignals zur Bereitstellung eines zweiten Taktsignals;

wobei die weitere Digitalfiltereinrichtung (106) umfaßt:

eine dritte Digitalfilterabschnittseinrichtung (106A), die an das zweite Taktsignal und das Multiplex-Ausgangssignal gekoppelt ist, um ein erstes gefiltertes Multiplexsignal zur Verfügung zu stellen;

eine vierte Digitalfilterabschnittseinrichtung (106B), die an das zweite Taktsignal und das erste gefilterte Multiplexsignal gekoppelt ist, um ein zweites gefiltertes Multiplexsignal zur Verfügung zu stellen; und

eine fünfte Digitalfilterabschnittseinrichtung (106B), die an das zweite Taktsignal und das zweite gefilterte Multiplexsignal gekoppelt ist, um ein drittes gefiltertes Multiplexsignal zur Verfügung zu stellen.

**9.** Schaltung nach einem der voranstehenden Ansprüche, bei welcher die Digitaloszillatoreinrichtung weiterhin umfaßt:

eine Binäradressiereinrichtung, die einen Eingangsport zum Empfang eines Frequenzinformationssignals und einen zusätzlichen Eingangsport, der an die Takteinrichtung gekoppelt ist, zur Bereitstellung eines Binäradressensignals aufweist;

eine Binärspeichereinrichtung, die an die Binäradressiereinrichtung gekoppelt ist, um mehrere gespeicherte Binärsignale zur Verfügung zu stellen; und

eine Kombinationseinrichtung, die so aufgebaut und angeordnet ist, daß sie die gespeicherten Binärsignale kombiniert, um das erste und zweite digitalisierte diskrete Zeitsignal zur Verfügung zu stellen.

**10.** Schaltung nach Anspruch 9, bei welcher die binäre Adressiereinrichtung eine erste und zweite Binärspeichereinrichtung aufweist, die aus mehreren Einzelbit-Speichereinrichtungen besteht.

**11.** Schaltung nach Anspruch 9 oder 10, bei welcher die Binärspeichereinrichtung einen Nur-Lese-Speicher umfaßt.

**12.** Schaltung nach einem der voranstehenden Ansprüche, bei welcher die digitale Quadraturmischereinrichtung (22, 24) weiterhin umfaßt:

eine erste (22) und eine zweite (24) diskrete Mischeinrichtung, die jeweils an das erste und zweite Eingangssignal sowie an das zugehörige erste bzw. zweite digitalisierte diskrete Zeitsignal gekoppelt sind, um das erste und zweite digitalisierte Ausgangssignal zur Verfügung zu stellen.

**13.** Schaltung nach Anspruch 12, bei welcher die erste und zweite Mischeinrichtung digitale Multiplizierer (56, 58) umfaßt.

**Revendications**

**1.** Circuit formant une section de sélectivité à fréquence intermédiaire nulle numérique, qui agit sur un signal d'entrée reconstitué dans un dispositif récepteur, comprenant, en combinaison :

un moyen formant une horloge (34) qui produit un signal d'horloge périodique ;

un moyen oscillateur numérique (26), couplé audit moyen formant une horloge, et servant à produire des premier et deuxième signaux discrets du point de vue temporel numérisés, de façon que ledit premier signal temporel discret numérisé soit en avance sur ledit deuxième signal temporel discret numérisé de 90° de phase ;

un moyen (22,24) servant à mélanger numériquement en quadrature le signal d'entrée et lesdits premier et deuxième signaux temporels discrets numérisés de façon à produire des premier et deuxième signaux de sortie numérisés qui occupent une bande de fréquence sélectionnée centrée sensiblement sur zéro hertz ; et

des premier et deuxième moyens de filtrage numériques (32 et 32') connectés audit moyen formant une horloge et audit moyen de mélange en quadrature numérique, servant à effectuer une limitation de bande sélective sur le spectre de fréquence desdits premier et deuxième signaux de sortie numérisés de façon à produire des premier et deuxième signaux de sortie numérisés filtrés, caractérisé en ce que chacun de ces moyens de filtrage comprend :

une section de filtre, intérieurement multiplexée, décomposée (64) qui est couplée auxdits signaux de sortie numérisés ;

un moyen (66) de réduction de taux d'échantillonnage, couplé à ladite section de filtre décomposée

;et

une section de filtre numérique sans multiplicateur (64B, 64C, 64D) couplée audit moyen de réduction du taux d'échantillonnage.

2. Circuit formant une section de sélectivité à fréquence intermédiaire nulle numérique, qui agit sur un signal d'entrée reconstitué dans un dispositif émetteur, comprenant, en combinaison :

un moyen formant une horloge (34) qui produit un signal d'horloge périodique ;

un moyen oscillateur numérique (26), couplé audit moyen formant une horloge, et servant à produire des premier et deuxième signaux discrets du point de vue temporel numérisés, de façon que ledit premier signal temporel discret numérisé soit en avance sur ledit deuxième signal temporel discret numérisé de 90° de phase ;

des premier et deuxième moyens de filtrage numériques (33, 33') couplés audit moyen formant une horloge et audit signal d'entrée servant à effectuer une limitation de bande sélective sur le spectre de fréquence desdits premier et deuxième signaux d'entrée de façon à produire des premier et deuxième signaux d'entrée filtrés ;

un moyen (22, 24) servant à mélanger numériquement en quadrature lesdits premier et deuxième signaux d'entrée filtrés et lesdits premier et deuxième signaux temporels discrets numérisés de façon à produire des premier et deuxième signaux de sortie numérisés qui occupent une bande de fréquence choisie sensiblement centrée sur zéro hertz ; et

caractérisé en ce que chacun de ces moyens de filtrage comprend :

une section de filtre, intérieurement multiplexée, décomposée (64) qui est couplée auxdits signaux d'entrée numérisés ;

un moyen (69) d'augmentation de taux d'échantillonnage, couplé à ladite section de filtre décomposée ; et

une section de filtre numérique sans multiplicateur (64B, 64C, 64D) couplée audit moyen d'augmentation du taux d'échantillonnage.

3. Circuit selon la revendication 1 ou 2, où ladite section de filtre intérieurement multiplexée décomposée comprend :

un moyen servant à produire un deuxième signal d'horloge périodique où ledit deuxième signal d'horloge possède une période approximativement égale à au moins deux fois la période dudit premier signal d'horloge ;

un moyen de démultiplexage (65A), couplé auxdits signaux de sortie numérisés, afin de les démultiplexer en au moins deux signaux démultiplexés ;

un premier moyen de filtrage (66A, 66B) servant à filtrer lesdits signaux démultiplexés afin de produire au moins deux signaux démultiplexés filtrés ;

un moyen de multiplexage (65B) servant à multiplexer lesdits signaux démultiplexés filtrés en un signal multiplexé qui représente une partie à bande sélectivement limitée dudit signal d'entrée ; et

un deuxième moyen de filtrage (67), couplé audit premier signal d'horloge et audit signal multiplexé, afin de produire un signal de sortie multiplexé combiné et filtré qui représente une partie à bande sélectivement limitée desdits signaux de sortie numérisés.

4. Circuit selon la revendication 1,2 ou 3, où chacune desdites sections de filtres numériques sans multiplicateur comprend :

un premier moyen d'addition binaire (68A) couplé à un signal d'entrée et à un deuxième signal retardé binaire afin de produire un premier signal de somme binaire ;

un premier moyen de décalage binaire (72A) couplé audit premier signal de somme binaire afin de produire un premier signal de somme binaire décalé ;

un deuxième moyen d'addition binaire (68B), couplé audit premier signal de somme décalé et à un premier signal retardé binaire, afin de produire un deuxième signal de somme binaire ;

un premier moyen de mémorisation binaire (70A), couplé audit deuxième signal de somme binaire, afin de produire ledit premier signal retardé binaire ;

un troisième moyen d'addition binaire (68C), couplé audit premier signal retardé binaire et audit deuxième signal binaire retardé, afin de produire un troisième signal de somme binaire ;

un deuxième moyen de décalage binaire (72B), couplé audit troisième signal de somme binaire, afin de produire un troisième signal de somme binaire décalé ;

un quatrième moyen d'addition binaire (68D), couplé audit troisième signal de somme binaire décalé et audit deuxième signal retardé binaire, afin de produire un quatrième signal de somme binaire

EP 0 216 803 B1

;
un deuxième moyen de mémorisation binaire (70B), couplé audit quatrième signal de somme binaire, afin de produire ledit deuxième signal retardé binaire.

5. Circuit selon la revendication 4, où ledit deuxième signal retardé binaire comprend le signal de sortie de filtre numérique.

6. Circuit selon l'une quelconque des revendications précédentes, où chacun desdits premier et deuxième moyens de filtrage numériques comprend en outre :
au moins deux sections de filtres numériques montées en cascade et servant à réaliser un filtre numérique d'un ordre sélectionné et couplées entre elles par un moyen d'augmentation de taux d'échantillonnage, afin de réduire la vitesse de fonctionnement des sections logiques suivantes.

7. Section de sélectivité à fréquence intermédiaire nulle numérique qui agit sur un signal d'entrée reçu dans un récepteur, comprenant, en combinaison :
un moyen formant une horloge (34) servant à produire au moins un premier et un deuxième signal d'horloge périodique ;
un moyen oscillateur numérique (26), couplé audit moyen formant une horloge, afin de produire des premier et deuxième signaux discrets du point de vue temporel numérisés, de façon que ledit premier signal temporel discret numérisé soit en avance sur ledit deuxième signal temporel discret numérisé de 90° de phase ;
un moyen (22,24) servant à mélanger numériquement en quadrature le signal d'entrée et lesdits premier et deuxième signaux numérisés afin de produire des premier et deuxième signaux de sortie numérisés, de façon que lesdits premier et deuxième signaux de sortie numérisés occcupent une bande de fréquence sélectionnée centrée sensiblement sur 0 Hz ;
des premier et deuxième moyens de filtrage numérique (100A et 100B), couplés audit moyen formant une horloge et audit moyen en quadrature numérique afin de produire des premier et deuxième signaux de sortie numérisés filtrés, caractérisée en ce que :
chacun desdits premier et deuxième moyens de filtrage numériques comprend au moins une section de filtrage numérique (64, 64'), couplée à un moyen de réduction de taux d'échantillonnage (66, 102A, 102B);
des moyens de multiplexage temporel (104) sont prévus, qui sont couplés auxdits premier et deuxième moyens de filtrage numériques afin de produire un signal de sortie multiplexé;
des moyens de filtrage numériques supplémentaires (106) sont prévus, qui sont couplés auxdits moyens de multiplexage, comprenant au moins une section de filtrage numérique, couplée audit moyen formant une horloge, afin de produire un filtre d'un ordre sélectionné et de produire un signal multiplexé filtré ; et
des moyens de démultiplexage temporel (108) sont prévus, qui sont couplés audit moyen formant une horloge et audit signal multiplexé filtré afin de produire des premier et deuxième signaux de sortie de façon que lesdits premier et deuxième signaux de sortie occupent une bande de fréquence sensiblement centrée sur 0 Hz.

8. Section de sélectivité à fréquence intermédiaire nulle numérique selon la revendication 7, comprenant en outre :
un moyen servant à diviser la fréquence dudit signal d'horloge de manière à produire un deuxième signal d'horloge ; où lesdits moyens de filtrage numériques supplémentaires (106) comprennent :
un troisième moyen formant une section de filtrage numérique (106A), couplé audit deuxième signal d'horloge et audit signal de sortie multiplexé afin de produire un premier signal multiplexé filtré ;
un quatrième moyen formant une section de filtrage numérique (106B) couplé audit deuxième signal d'horloge et audit premier signal multiplexé filtré, afin de produire un deuxième signal multiplexé filtré ; et
un cinquième moyen formant une section de filtrage numérique (106B) couplé audit deuxième signal d'horloge et audit deuxième signal multiplexé filtré afin de produire un troisième signal multiplexé filtré.

9. Circuit selon l'une quelconque des revendications précédentes, où ledit moyen oscillateur numérique comprend en outre :
un moyen d'adressage binaire possédant un accès d'entrée qui sert à recevoir un signal

18

d'information de fréquence et un accès d'entrée supplémentaire couplé audit moyen formant une horloge afin de produire un signal d'adresse binaire ;

un moyen de mémorisation binaire couplé audit moyen d'adressage binaire afin de produire plusieurs signaux binaires mémorisés ; et

un moyen de combinaison construit et conçu pour combiner lesdits signaux binaires mémorisés afin de produire lesdits premier et deuxième signaux discrets du point de vue temporel numérisés.

**10.** Circuit selon la revendication 9, où ledit moyen d'adressage binaire comporte un premier et un deuxième moyen de mémorisation binaire constitués par plusieurs moyens de mémorisation d'un seul bit.

**11.** Circuit selon la revendication 9 ou 10, où ledit moyen de mémorisation binaire comprend une mémoire morte.

**12.** Circuit selon l'une quelconque des revendications précédentes, où ledit moyen de mélange en quadrature numérique (22,24) comprend en outre :

un premier et un deuxième moyen de mélange discrets (22 et 24) qui sont couplés chacun respectivement auxdits premier et deuxième signaux d'entrée et à l'un, respectif, desdits premier et deuxième signaux temporels discrets numérisés afin de produire lesdits premier et deuxième signaux de sortie numérisés.

**13.** Circuit selon la revendication 12, où lesdits premier et deuxième moyens de mélange comprennent des multiplicateurs numériques (56,58).

Fig. 1

Fig. 2

*Fig. 3*

FREQUENCY
INFORMATION

CHANNEL
FREQUENCY
LATCH — 44

26

46 — Σ

FROM
CLOCK → PHASE ACCUMULATOR — 48

$\emptyset_C$          $\emptyset_f$

50 — ROM ROM — 52          ROM — 54

COS $\emptyset_C$          SIN $\emptyset_C$          SIN $\emptyset_f$

× — 56          Σ — 60          COS $2\pi f_C nT$
                                28

× — 58  62          Σ — 62          SIN $2\pi f_C nT$
                                30

21

Fig. 4a

Fig. 4b

Fig. 6

Fig. 7c

Fig. 7a

Fig. 8

Fig. 7b

Fig. 9a

Fig. 9b

FREQUENCY (MHz)

Fig. 10

FREQUENCY (MHz)

Fig. 5

64

68A, 72A, 68B, 70A, 68C, 72B, 68D, 70B
SHIFT, LATCH, SHIFT, LATCH
CLOCK

Fig. 11

64'

65A DE-MULTIPLEXER, 66A DECOMPOSED FILTER, 66B DECOMPOSED FILTER, 65B MULTIPLEXER, 67 COMBINING FILTER, ÷2, CLOCK

# Fig. 12a

# Fig. 12b

# Fig. 12c

# Fig. 13a

# Fig. 13b

# Fig. 13c

*Fig. 14a*

*Fig. 14b*

*Fig. 14c*

*Fig. 15a*

*Fig. 15b*

Fig. 15c

Fig. 16

Fig. 17

*Fig. 18*

EP 0 216 803 B1